# EUROPEAN PATENT APPLICATION

(11) **EP 1 434 090 A1**
(43) Date of publication of application: **30.06.2004**
(21) Application number: 02772888.0
(22) Date of filing: 24.09.2002
(51) Int. Cl.: G03F 7/022, G03F 7/033, C08L 33/00, H01L 21/027

(54) **PHOTOSENSITIVE RESIN COMPOSITION**

(30) Priority: 27.09.2001 JP 2001295662; 21.12.2001 JP 2001389601
(71) Applicant: Clariant International Ltd., 4132 Muttenz (CH)
(72) Inventor: TAKAHASHI, Shuichi, Ogasa-gun, Shizuoka 437-1496 (JP); KAWATO, Shunji, Ogasa-gun, Shizuoka 437-1496 (JP)
(74) Representative: Hütter, Klaus, Dr.
(86) International application number: PCT/JP2002/009745
(87) International publication number: WO 2003/029898

(57) **Abstract**

A photosensitive resin composition comprising an alkali-soluble acrylic resins, e.g. a copolymer of alkyl(meth)acrylate and (meth)acrylic acid, a photosensitizer having a quinone diazide group, a polycyclic phenolic compound represented by the general formula (I) described below and if necessary a hardening agent having an epoxy group for forming a planarization film or an interlayer dielectric film having high heat resistance, high insulation, high resolution and high transmittance which are applied for a semiconductor or a flat panel display and a thin film pattern forming method therewith. 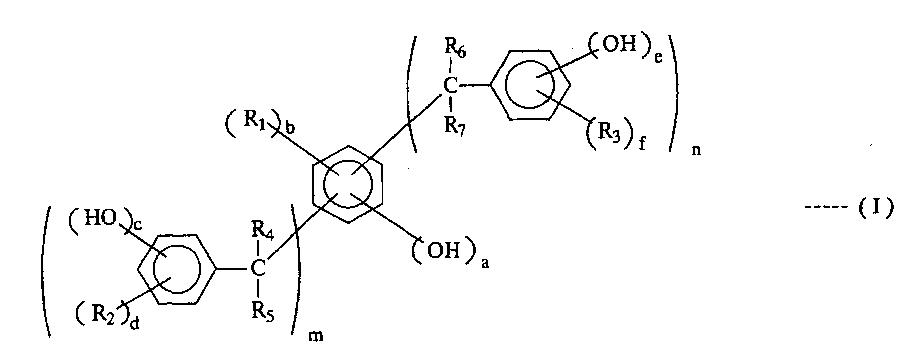 wherein R₁, R₂, R₃, R₄ , R₅, R₆ and R₇ independently represent H, a C₁₋₄ alkyl group or 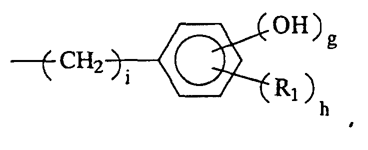 m and n independently represent an integer of 0 to 2, each of a, b, c, d, e, f, g and h is an integer of 0 to 5 satisfying a + b ≤ 5, c + d ≤ 5, e + f ≤ 5 and g + h ≤ 5, and i is an integer of 0 to 2.

## Description

### Technical field of the present Invention

The present invention relates to a photosensitive resin composition, further in detail to a photosensitive resin composition which is suitable for manufacture of a semiconductor device and a flat panel display (FPD), etc. particularly for a formation of a planarization film or an interlayer dielectric film applied for a semiconductor device and an FPD, etc.; to a semiconductor device and an FPD having a planarization film or an interlayer dielectric film which is formed by the photosensitive resin composition; and to a heat-resistant thin film forming method using the photosensitive resin composition.

### Background art

In the various fields such as manufacture of semiconductor integrated circuits such as LSI, a display face of FPD such as a liquid crystal display equipment and a plasma display, manufacture of a circuit substrate for thermal head etc., and the like, photolithography technology has so far been employed for forming microelements or for conducting fine processing. In the photolithography technology, a positive- or negative-working photosensitive resin composition has been used to form a resist pattern. Recently the formation technology of a planarization film or an interlayer dielectric film for a semiconductor integrated circuit or an FPD display face, etc. is being paid attention as the new applications for these photosensitive resin compositions. Particularly the market's demand to realize the high micronization of picture elements in the FPD display face is strong. To attain such high micronization, it is said that the positive-working photosensitive resin composition is necessary which can form a planarization film or an interlayer dielectric film having a fine pattern with high transparency and an excellent insulation property. High heat resistance is required for the photosensitive resin composition used for these applications besides the insulation property and the planarization film-forming property. Various kinds of studies are being made so far to meet these requirements, many technologies are being proposed such as Japanese Patent Application Laid-open No. Hei 7(1995)-248629, Japanese Patent Application Laid-open No. Hei 8(1996)-262709, etc. for example. However the compositions described in these literatures require flat-exposure to light (bleaching process) and a heat treatment (post bake process) wherein a photosensitizer is decomposed in order to improve a transparency of the film. In addition, because of containing a crosslinking group such as an epoxy group in the main chain of an alkali-soluble resin constituting the composition, an extraordinary caution is required to the preservation atmosphere of the composition compared with a general positive-working resist, which is used for a fine processing, due to a stability of time dependency and a special material is also required as the materials used for the composition.

Further more a recycled developer which is utilized repeatedly is used for the lithography in a manufacturing process of an FPD display face. When a positive-working resist used for manufacture of a TFT and the photosensitive resin composition containing said crosslinking groups, etc. are mixed in this recycled developer, there is a problem that is an occurrence of a great amount of insoluble precipitates in a developer by the reaction between the positive-working resist and the crosslinking groups contained in the photosensitive resin composition.

On the other hand, in Japanese Patent Application Laid-open No. Hei 4(1992)-352101 which is titled "Radiation-sensitive resin composition for micro lens", a composition comprising an alkali-soluble resin (A), for example novolak resin or a copolymer of α,β-unsaturated carboxylic acid such as a copolymer of acrylic acid, methacrylic acid, etc. and other radically polymerizable compounds, i.e. methacrylic alkyl esters such as methyl methacrylate and n-butyl methacrylate or hydroxyl alkyl esters such as 2-hydroxyethyl methacrylate and 2-hydroxypropyl methacrylate; a radiation sensitive acid generating compound (B), for example 1,2-naphthoquinone diazide-4-sulfonic ester, 1,2-naphthoquinone diazide-5-sulfonic ester, etc. with 2,3,4,4'-tetrahydroxy benzophenone, 4,4'-[1-[4-[1-(4-hydroxyphenyl)-1-methylethyl]phenyl]etylidene]diphenol, etc.; and a compound having at least two epoxy groups in a molecule (C) is described. This invention discloses that a resist pattern is formed with a photosensitive resin composition and the resist pattern is made melt-flowing by the heat treatment to form a micro lens. In this literature, there is also a description that a possible lens formation temperature to form a lens is 120 to 170° C, however there is no descriptions that it is possible to form a thin film having high heat resistance at 220°C or higher.

Referring to the situation described above, the objects of the present invention is to offer a photosensitive resin composition comprising an alkali-soluble resin and a photosensitizer, which has a good retention of planarity of a film surface after baking at the high temperature even though without using a crosslinking agent, makes it possible to form a good film having high resolution and high light transmittance, and has an insulation property and good stability of time dependency, and also to offer a photosensitive resin composition having stability of time dependency which is as good as that of without using a crosslinking agent besides having the aforementioned characteristics when using a crosslinking agent. A object of the present invention further includes to offer a semiconductor devise or an FPD which is formed by these photosensitive resin compositions and to offer a thin film forming process with heat resistance using these photosensitive resin compositions.

### Disclosure of the Invention

As a result of eager studies and examinations, the present inventors found that the above-described object can be attained by using a particular resin as an alkali-soluble resin in a photosensitive resin composition comprising an alkali-soluble resin and a photosensitizer containing a quinone diazide group and by incorporating a particular phenolic compound. It means that the present inventors found that a photosensitive resin composition had a good stability of time dependency, kept a planarity of film surface even after high temperature heat treatment such as at 220°C for 1 hour, represented good light transmittance and a high insulation property, and was suitable for a forming material of a planarization film or an interlayer dielectric film of a semiconductor integrated circuit, an FPD, etc. and then the present invention was made.

It means that the present invention offers a photosensitive resin composition comprising an alkali-soluble resin and a photosensitizer containing a quinone diazide group, wherein it is characterized in that the alkali-soluble resin is acrylic resin and said composition contains a phenolic compound represented by the general formula (I): 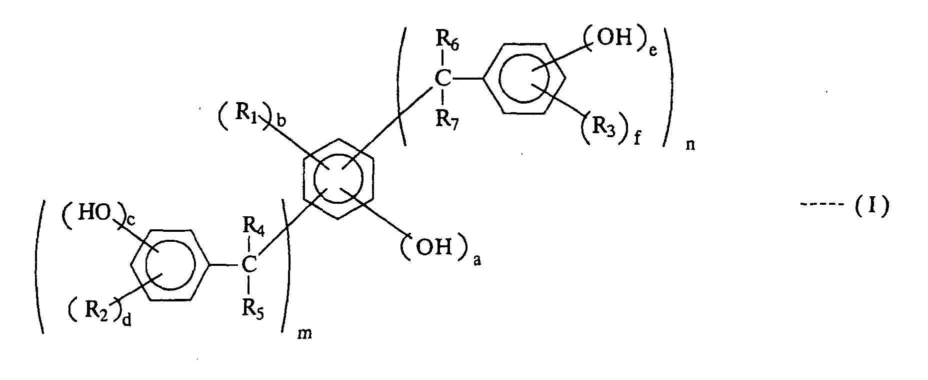 wherein R₁, R₂, R₃, R₄, R₅, R₆ and R₇ independently represent H, a C₁₋₄ alkyl group or 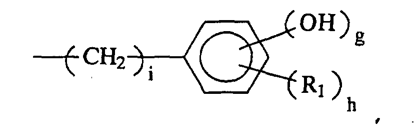 m and n independently represent an integer of 0 to 2, each of a, b, c, d, e, f, g and h is an integer of 0 to 5 satisfying a + b ≤ 5, c + d ≤ 5, e + f ≤ 5 and g + h ≤ 5, and i is an integer of 0 to 2.

And also the present invention offers the above-described photosensitive resin composition that is characterized in further containing a hardening agent having an epoxy group.

Further, the present invention offers an FPD or a semiconductor devise having a planarization film or an interlayer dielectric film that are formed by the above-described photosensitive resin composition.

Furthermore, the present invention offers a method for forming a heat-resistant thin film, wherein after forming a pattern using above-described photosensitive resin composition, a uniform-exposure of the whole area (flat-exposure to light) is not conducted in the case that no hardening agent having an epoxy group is contained in the photosensitive resin composition and an flat-exposure to light is conducted in the case that a hardening agent having an epoxy group is contained, after that the resist pattern is post-baked.

### Detailed explanation of the Invention

Hereinafter, the present invention will be further described in more detail.

The photosensitive resin composition of the present invention comprises an alkali-soluble resin and a photosensitizer containing a quinone diazide group, and further an alkali-soluble resin is acrylic resin and said composition contains a phenolic compound represented by above-described general formula (I).

Alkali-soluble acrylic resins used in the photosensitive resin composition of the present invention include alkali-soluble polyacrylic esters (a), alkali-soluble polymethacrylic esters (b) and alkali-soluble poly(acrylic ester-co-methacrylic ester) containing at least one kind of acrylic esters and at least one kind of methacrylic esters as a constitutional unit (c). These acrylic resins are used singly or are used together of two kinds or more. And also these acrylic resins contain favorably an organic acid monomer to make a resin alkali-soluble as a copolymerization component, however the copolymerization component to make a resin alkali-soluble is not limited in the organic acid monomer.

A monomer component constituting these alkali-soluble polyacrylic esters, polymethacrylic esters and poly(acrylic ester-co-methacrylic ester) includes an acrylic ester, a methacrylic ester, an organic acid monomer and other copolymerizable monomers.

A monomer component constituting these polymers includes acrylic esters, methacrylic esters, and organic acid monomers exemplified below.

### Acrylic ester:

Methyl acrylate, ethyl acrylate, n-propyl acrylate, n-butyl acrylate, n-hexyl acrylate, isopropyl acrylate, isobutyl acrylate, t-butyl acrylate, cyclohexyl acrylate, benzyl acrylate, 2-chloroethyl acrylate, methyl-α-chloroacrylate, phenyl α-bromoacrylate, etc.

### Methacrylic ester:

Methyl methacrylate, ethyl methacrylate, n-propyl methacrylate, n-butylmethacrylate, n-hexylmethacrylate, isopropyl methacrylate, isobutyl methacrylate, t-butyl methacrylate, cyclohexyl methacrylate, benzyl methacrylate, phenyl methacrylate, 1-phenylethyl methacrylate, 2-phenylethyl methacrylate, furfuryl methacrylate, diphenylmethyl methacrylate, pentachlorophenyl methacrylate, naphthyl methacrylate, iso-boronyl methacrylate, benzyl methacrylate, hydroxyethyl methacrylate, hydroxypropyl methacrylate, etc.

### Organic acid monomer:

Mono carboxylic acid such as acrylic acid, methacrylic acid, crotonic acid, etc., dicarboxylic acid such as itaconic acid, maleic acid, fumaric acid, citraconic acid, metaconic acid, etc. , anhydrides of these dicarboxylic acids, 2-acryloyl hydrogen phthalate, 2-acryloyl oxypropyl hydrogen phthalate, etc.

Other copolymerizable monomers include maleic diester, fumaric diester, styrene and a styrene derivative, acrylonitrile, (meth)acrylamide, vinyl acetate, vinyl chloride, vinylidene chloride, etc. These other copolymers may be used if necessary and when used, the quantity thereof is within the limit that an acrylic resin can attain the object of the present invention.

In the present invention, a preferable acrylic resin is a copolymer containing a constitutional unit derived from alkyl(meth)acrylate and a constitutional unit derived from (meth)acrylic acid, more preferable acrylic resin is one containing 5 to 30 mole-% of (meth)acrylic acid. On the other hand, a preferable limit of weight average molecular weight as determined by polystyrene standards of the acrylic resin of the present invention is 20,000 to 40,000, more preferably 25,000 to 30,000. If the weight average molecular weight as determined by polystyrene standards of the acrylic resin is less than 20,000, heat resistance of the obtained film shows a tendency to be deteriorated. And also if it exceeds 40,000, there may take place problems in resolution, sensitivity, a film forming property, etc.

A photosensitizer having a quinone diazide group which is used in the photosensitive resin composition of the present invention may be any one if it is a photosensitizer having a quinone diazide group. Of the photosensitizers, it is preferred that the one which is obtained by reacting a naphthoquinone diazide sulfonic halide such as 1,2-naphthoquinone diazide-5-sulfonyl chloride and 1,2-naphthoquinone diazide-4-sulfonyl chloride or a benzoquinone diazide sulfonic halide such as 1,2-bonzoquinone diazide-5-sulfonyl chloride and 1,2-bonzoquinone diazide-4-sulfonyl chloride with a low or high molecular compound having a functional group which is condensable with this acid halide. The functional group which is condensable with acid halide includes a hydroxyl group, an amino group, etc. and particularly a hydroxyl group is preferable. A low molecular compound containing a hydroxyl group includes the phenolic compound represented by the above described general formula (I). If a compound containing a hydroxyl group represented by the above described general formula (I) is not used, there may occur a problem in a solubility of the obtained ester compound into a photosensitive resin composition. These photosensitizers having a quinone diazide group is used usually at 1 to 30 parts by weight relative to 100 parts by weight of a resin component in a photosensitive resin composition of the present invention.

The photosensitive resin composition of the present invention further contains the phenolic compound represented by the above-described general formula (I). The low molecular compound having a phenolic hydroxyl group represented by the above-described general formula (I) is favorably and suitably used in the photosensitive resin composition of the present invention for controlling a dissolution rate as a dissolution promoter usually for an exposed area because of a low molecular compound or for controlling sensitivity of a photosensitive resin composition. These controlling of the dissolution rate or the sensitivity can be made within a certain limit by increasing or decreasing an adding amount of these phenolic compounds. The adding amount of these phenolic compounds may be chosen an adequate amount according to a resin used or its molecular weight. Furthermore as for an unexposed area, a phenolic compound is azo-coupling-reacted with a photosensitizer upon development to contain the reaction product as a dissolution inhibiting component of a low molecular compound in a resin component to be dissolution-inhibited. As a result, the difference of a dissolution rate between an exposed area and an unexposed area, i.e. contrast can be made large to enable to improve a resolution.

The low molecular compound having a phenolic hydroxyl group represented by the above described general formula (I) includes o-cresol, m-cresol, p-cresol, 2,4-xylenol, 2,5-xylenol, 2,6-xylenol, bisphenol A, B, C, E, F or G, 4,4',4''-methylidyne trisphenol, 2,6-bis[(2-hydroxy-5-methylphenyl)methyl]-4-methylphenol, 4,4'-[1-[4-[1-(4-hydroxyphenyl)-1-methylethyl]phenyl]-ethylidene]bisphenol, 4,4'-[1-[4-[2-(4-hydroxyphenyl)-2-propyl]phenyl]ethylidene]bisphenol, 4,4',4''-ethylidyne trisphenol, 4-[bis(4-hydroxyphenyl)methyl]-2-ethoxyphenol, 4,4'-[(2-hydroxyphenyl)methylene]-bis[2,3-dimethylphenol], 4,4'-[(3-hydroxyphenyl) methylene]bis[2,6-dimethylphenol], 4,4.'-[(4-hydroxyphenyl)methylene]bis[2,6-dimethylphenol], 2,2'-[(2-hydroxyphenyl)methylene]bis[3,5-dimethylphenol], 2,2'-[(4-hydroxyphenyl)methylene]bis[3,5-dimethylphenol], 4,4'-[(3,4-dihydroxyphenyl)methylene]bis[2,3,6-trimethyl phenol], 4-[bis(3-cyclohexyl-4-hydroxy-6-methylphenyl)methyl]-1,2-benzenediol, 4,6,-bis[(3,5-dimethyl-4-hydroxyphenyl)methyl]-1,2,3-benzenetriol, 4,4'-[(2-hydroxyphenyl)methylene]bis[3-methylphenol], 4,4',4''-(3-methyl-1-propanyl-3-ylydine)trisphenol, 4,4',4'',4'''-(1,4-phenylenedimethylidine)tetrakis-phenol, 2,4,6-tris[(3,5-dimethyl-4-hydroxyphenyl)methyl]-1,3-benzenediol, 2,4,6-tris[(3,5-dimethyl-2-hydroxyphenyl)methyl]-1,3-benzenediol, 4,4'-[1-[4-[1-[4-hydoxy-3,5-bis[(hydroxy-3-methylphenyl)methyl]phenyl]-1-methylethyl]phenyl]-ethylidene]bis[2,6-bis(hydroxy-3-methylphenyl) methyl]phenol, etc. The preferable compounds include 4,4',4''-methylidine trisphenol, 2,6-bis[(2-hydroxy-5-methylphenyl)methyl]-4-methylphenol, 4,4'-[1-[4-[1-(4-hydroxyphenyl)-1-methylethyl]phenyl]ethylidene]-bisphenol, 4,4'-[1-[4-[2-(4-hydroxyphenyl)-2-propyl]phenyl]ethylidene]-bisphenol, 4,4',4 "-ethylidine trisphenol, etc.

Among these low molecular compounds having a phenolic hydroxyl group, a compound represented by the formula (II) or (III) described below are preferable.

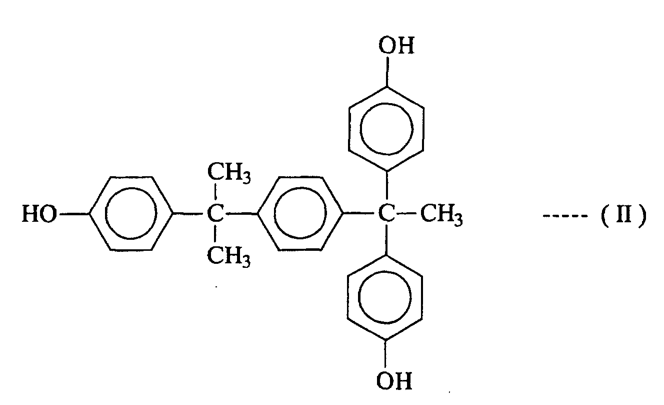

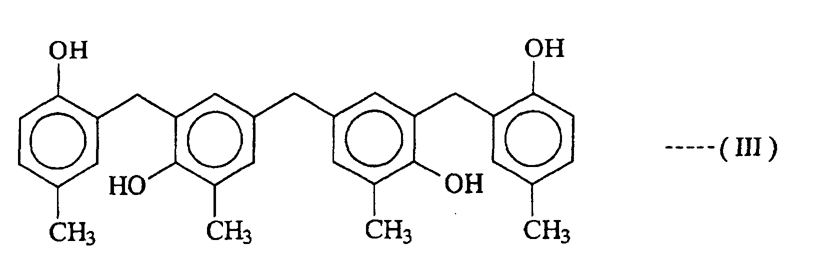

These low molecular compounds having a phenolic hydroxyl group is used at the dosage of 1 to 20 parts by weight relative to 100 parts by weight of an alkali-soluble resin.

And also in a photosensitive resin composition of the present invention, a hardening agent having an epoxy group can be incorporated. This hardening agent having an epoxy group includes a high molecular type epoxy resin such as bisphenol A type epoxy resin, bisphenol F type epoxy resin, phenol novolak type epoxy resin, cresol novolak type epoxy resin, alicyclic epoxy resin, glycidyl ester type epoxy resin, glycidyl amine type epoxy resin, and heterocyclic epoxy resin. Not only above described high molecular type epoxy resin, but also a diglycidyl ether of bisphenol A or bisphenol F and so on which are a low molecular type epoxy compound can be used as a hardening agent in the present invention. The preferable hardening agents include a three functional epoxy resin, and as the three functional epoxy resin there can be concretely exemplified with Techmore (trade name) VG 3101 and Techmore VG 3101L produced by Mitsui Chemical company, etc.

Solvents which dissolve an alkali-soluble resin, a photosensitizer, a compound or a resin having phenolic hydroxyl group and a hardening agent having an epoxy group of the present invention preferably include ethylene glycol monoalkyl ethers such as ethylene glycol monomethyl ether, ethylene glycol monoethyl ether, etc.; ethylene glycol monoalkyl ether acetates such as ethylene glycol monomethyl ether acetate, ethylene glycol monoethyl ether acetate, etc.; propylene glycol monoalkyl ethers such as propylene glycol monomethyl ether, propylene glycol monoethyl ether, etc.; propylene glycol monoalkyl ether acetates such as propylene glycol monomethyl ether acetate, propylene glycol monoethyl ether acetate, etc.; lactic esters such as methyl lactate, ethyl lactate, etc.; aromatic hydrocarbons such as toluene, xylene, etc.; ketones such as methyl ethyl ketone, 2-heptanone, cyclohexanone, etc.; amides such as N,N-dimethylacetamide, N-methylpyrrolidone, etc.; lactones such as γ-butyrolactone, etc.; and the like. These solvents may be used singly or in a mixture of two or more thereof.

In the photosensitive resin composition of the present invention, there may be incorporated, if necessary, adhesion aids, surfactants, etc. Examples of the adhesion aids include alkylimidazolines, butyric acid, alkyl acids, polyhydroxystyrene, polyvinyl methyl ether, t-butylnovolak, epoxysilane, epoxy polymers, silanes, etc., and examples of the surfactants include nonionic surfactants such as polyglycols and the derivatives thereof, i.e., polypropylene glycol or polyoxyethylene lauryl ether, etc.; fluorine-containing surfactants such as Fluorad (trade name; product of Sumitomo 3M Co. , Ltd. ) , Megafac (trade name; product of Dai-Nippon Ink & Chemicals, Inc . ) , Surflon (trade name; product of Asahi Glass Company, Ltd.) and organosiloxane surfactants such as KP341 (trade name; product of Shin-Etsu Chemical Co., Ltd).

The photosensitive resin composition of the present invention is prepared by dissolving the above described components at the determined dosage in a solvent. At this time each component may be dissolved in advance respectively in a solvent and each dissolved component may be mixed and prepared at the determined ratio right before usage. Usually the solution of a photosensitive resin composition is provided for its use after filtered with 0.2 µm filter, etc.

The photosensitive resin composition of the present invention is made highly insulating, highly transparent and highly heat-resistant thin film by the following methods. And then this film can be utilized favorably and suitably as a planarization film or an interlayer dielectric film. It means that first the solution of the photosensitive resin composition of the present invention is applied on a substrate whereupon, a circuit pattern or a semiconductor device, etc. are formed if necessary and a pre-bake is conducted to form a coated film of the photosensitive resin composition. Next, this substrate is exposed to light pattern wise through a determined mask, developed by using an alkali developer, and rinsed if necessary to form a thin film positive pattern of the photosensitive resin composition. The thin film positive pattern formed in this way is post-baked and is utilized as a planarization film or an interlayer dielectric film of a semiconductor or an FPD such as a liquid crystal display equipment and a plasma display when a photosensitive resin composition does not contain a hardening agent having an epoxy group. On the other hand, when a photosensitive resin composition contains a hardening agent having an epoxy group, after the pattern is full-exposed to light, post-baked, thereby a thin film with higher heat resistant temperature can be formed. The reason thereof is thought that a photosensitizer is decomposed by the flat-exposure to light at this moment to form an acid and a hardening reaction of a hardening agent having an epoxy group is accelerated by the acid. Further hardening is also accelerated by heating to form a film with higher heat resistance.

In the above described formation of a thin film, as a coating method of the photosensitive resin composition solution, an optional method can be applied such as a spin coat method, a roll coat method, a land coat method, a spray method, a flow spreading coat method, a dip coat method, etc. A radiation to be used for an exposure to light can include ultra violet light such as g-line, i-line, etc., deep ultra violet light such as KrF eximer laser or ArF eximer laser, etc., X-ray, electron beams, etc., for example. Further a development method includes a method so far applied for a resist development method such as a paddle development method, a dipping development method, and a swinging dip development method. A developer includes inorganic alkali such as sodium hydroxide, potassium hydroxide, sodium carbonate, and sodium silicate, ammonia, organic amine such as ethylamine, propylamine, diethylamine, diethylamino ethanol, and triethylamine, tertiary amine such as tetramethylammonium hydroxide, etc. An organic amine containing no metal ion is preferred in the formation of a planarization film or an interlayer dielectric film.

And also a radiation applied for the flat-exposure to light may be the same radiation as one used for patterning or a different one. The exposure dose of the flat-exposure to light can be applied at 600 mJ/cm² or higher with g-, h-, and i-line mixed light. The post-bake is made usually at the temperature of around 150 to 300° C, more preferably at the temperature of 200 to 250° C.

### Best mode for practicing the Invention

The present invention will now be described more specifically by reference to Examples which, however, are not to be construed to limit the present invention in any way.

### Example 1

### <Preparation of Photosensitive Resin Composition>

100 parts by weight of poly(methyl methacrylate-co-2-hydroxypropyl methacrylate-co-methacrylic acid) [the containing ratio of methacrylic acid, 15 mole-%] , the weight average molecular weight of which is 25,000 as determined by polystyrene standards, 17 parts by weight of the esterified product between the compound represented by the above-described formula (II) and 1,2-naphthoquinone diazide-5-sulfonyl chloride, and 10 parts by weight of the phenolic compound represented by the above-described formula (II) were dissolved in propylene glycol monomethyl ether acetate. Then the solution was stirred after 300 ppm of Megafac R-08 (produced by Dai-Nippon Chemicals & Inks Co., Inc.) was added in order to prevent a radial wrinkles which was so called "striation" and was formed in the surface of a resist film upon a rotational coating followed by filtrating with 0.2 µm filter to prepare a solution of a photosensitive resin composition.

### <Measurement of Limit of Resolution and Formation of Thin Film Pattern>

The composition was applied on a 4-inch silicon wafer by a rotational coating and was baked on a hot plate at 100°C for 90 seconds to form a resist film of 3.0 µm in thickness. A test pattern of contact holes with various kind of diameters was exposed to light on the resist film at an optimal exposure dose by g + h + i-line mask aligner produced by Canon Corporation (PLA-501F), and the exposed resist film was developed at 23° C for 60 seconds with 0.4 weight-% aqueous solution of tetramethylammonium hydroxide to form contact hole patterns. Hole diameters of the patterns were observed by a scanning electronic microscope and a limit of resolution was measured. And also the 4-inch wafer whereon patterns were formed was post-baked by heating at 220° C for 60 minutes in an oven.

### <Evaluation of Heat Resistance>

While post-bake treatment was made at 220° C for 60 minutes, a form change of a contact hole with 5 µm in diameter was observed by a scanning electronic microscope. The results were evaluated by the way that ○ was put when no flowing of a pattern was observed and X was put when flowing was observed. The result is shown in Table 1.

### <Evaluation of Transmittance>

After a coated film was formed by conducting the same operation as described above except using a quartz glass substrate instead of a 4-inch silicon wafer, a heat treatment was made at 220° C for 60 minutes to obtain a glass substrate having a thin film pattern. And then the transmittance of this glass substrate having a thin film pattern at 400 nm wavelength was measured using ultra violet - visible light spectrophotometer, CARY4E (Ballian company) and the results were evaluated by the way that ○ was put when a transmittance was 85% or higher and X was put when it was lower than 85%. The result is shown in Table 1.

### Example 2

The same manner was taken as Example 1 except using the esterified product between the compound represented by the above-described formula (III) and 1,2-naphthoquinone diazide-5-sulfonyl chloride instead of the esterified product between the compound represented by the above-described formula (II) and 1,2-naphthoquinone diazide-5-sulfonyl chloride and using 10 parts by weight of a phenolic compound represented by the formula (III) instead of 10 parts by weight of a phenolic compound represented by the formula (II) and the result in Table 1 was obtained.

### Example 3

### <Preparation of photosensitive resin composition>

100 parts by weight of poly(methyl methacrylate-co-2-hydroxypropyl methacrylate-co-methacrylic acid) [the containing ratio of methacrylic acid, 15 mole-%] , the weight average molecular weight of which is 25,000 as determined by polystyrene standards, 26 parts by weight of the esterified product between the compound represented by the above-described formula (II) and 1,2-naphthoquinone diazide-5-sulfonyl chloride, 10 parts by weight of the phenolic compound represented by the above-described formula (II), and 2.5 parts by weight of bisphenol A type epoxy resin, Epicoat 828 (produced by Yuka Shell Epoxy company) were dissolved in propylene glycol monomethyl ether acetate. The solution was stirred after 300 ppm of Megafac R-08 (produced by Dai-Nippon Chemicals & Inks Co., Inc.) was added in order to prevent a radial wrinkles which was so called "striation" and was formed in the surface of a resist film upon a rotational coating, and then filtrated with 0.2 µm filter to prepare the solution of a photosensitive resin composition.

### <Measurement of Limiting Resolution and Formation of Thin Film Pattern>

The composition was applied on a 4-inch silicon wafer by a rotational coating and was baked on a hot plate at 100° C for 90 seconds to form the resist film of 3.0 µm in thickness. A test pattern of contact holes with various kinds of diameters was exposed to light on the resist film at an optimal exposure dose by g + h + i-line mask aligner produced by Canon Corporation (PLA-501F), was developed at 23° C for 60 seconds with 0.4 weight-% aqueous solution of tetramethylammonium hydroxide to form contact hole patterns. Hole diameters of the pattern were observed by a scanning electronic microscope and a limiting resolution was measured. And also the 4-inch wafer whereon patterns were formed was full-exposed to light using the aligner described above and then post-baked by heating at 220°C for 60 minutes in an oven.

### <Evaluation of Heat Resistance and Transmittance>

Heat resistance and transmittance were evaluated in the same manner as Example 1 and the result in Table 1 was obtained.

### <Evaluation of Solvent Resistance>

The photosensitive resin composition was applied on a 4-inch silicon wafer by a rotational coating and baked on a hot plate at 100° C for 90 seconds to form the resist film of 3.0 µm in thickness. After that, the resist film was developed with 0.4 weight-% aqueous solution of tetramethylammonium hydroxide at 23°C for 50 seconds. Further the resist film after development was exposed to light at the exposure dose of 600 mJ/cm² with a full light exposure equipment produced by Canon Corporation (PLA-501F) and heated up in a vacuum drying oven at 220°C for 1 hour to prepare a substrate for evaluation of solvent resistance. This substrate for evaluation of solvent resistance was dipped in N-methyl-2-pyrrolidone at room temperature (23°C) for 5 minutes and the film thicknesses of before and after dipping were measured. The evaluation of solvent resistance of the photosensitive resin composition was conducted by the reduction quantity (A) of resist film thickness before and after dipping in N-methylpyrrolidone. The result is shown in Table 1.

### Example 4

The same manner was taken as Example 3 except using 4 parts by weight of Techmore VG 3101L (produced by Mitsui Chemical company) instead of 2. 5 parts by weight of Epicoat 828 and the result in Table 1 was obtained.

### Comparative Example 1

The same manner was taken as Example 1 except using no phenolic compound and the result in Table 1 was obtained.

### Comparative Example 2

The same manner was taken as Example 1 except using phenol novolak resin (the weight average molecular weight was 15,000 as determined by polystyrene standards) instead of the phenolic compound represented by the above-described formula (II) and the result in Table 1 was obtained.

### Comparative Example 3

The same manner was taken as Example 3 except using no phenolic compound represented by the above-described formula (II) and the result in Table 1 was obtained. As shown in Table 1, the thin film pattern on Comparative Example 3 gave the good results in terms of film remaining ratio, heat resistance and transmittance, however an insoluble substance (development residue) was observed after development and then a practically sufficient performance could not be obtained.

**Table 1**

| | Film remaining ratio % | Heat resistance | Transmittance | Limiting resolution | Solvent resistance (Å) |
|---|---|---|---|---|---|
| Example 1 | 82.0 | ○ | ○ | 4 | - |
| Example 2 | 81.0 | ○ | ○ | 4 | - |
| Example 3 | 99.0 | ○ | ○ | 4 | 3000 |
| Example 4 | 99.0 | ○ | ○ | 4 | 300 |
| Comparative Example 1 | 71.1 | ○ | ○ | 6 | - |
| Comparative Example 2 | 95.0 | X | X | 8 | - |
| Comparative Example 3 | 99.0 | ○ | ○ | 6 | - |

The insulating properties of the heat-resistant thin films obtained by the above-described Examples were so good as to use as a planarization film or an interlayer dielectric film of a semiconductor and an FPD.

Furthermore after the photosensitive resin compositions of the above-described Examples and Comparative Examples were kept for 3 months at room temperature, the same tests were conducted as Examples and Comparative Examples and the obtained results were the same as those of Examples and Comparative Examples.

From the above, it is found that the photosensitive resin composition of the present invention can keep film surface planarity after baking at high temperature even though using no crosslinking agent, it means it can provide a film of good quality having high resolution, high light transmittance, and a high insulating property together with high heat resistance, further stability of time dependency was proved to be good. Examples 3 and 4 prove that the heat resistance and solvent resistance of the film obtained by the photosensitive resin composition are further improved by using a hardening agent having an epoxy group, in particular excellent solvent resistance is obtained using a three-functional epoxy resin as a hardening agent and the photosensitive resin composition having good stability of time dependency could also be obtained.

### Effectiveness of Invention

As mentioned above, the photosensitive resin composition of the present invention has high heat resistance, a high insulating property, high resolution, good solvent resistance together with high light transmittance after post-baking and further good stability of time dependency and therefore it can be used favorably and suitably for a formation material for a planarization film and an interlayer dielectric film, etc. for a semiconductor, an FPD, etc. which require those various kinds of characteristics.

### Industrial Applicability

The photosensitive composition of the present invention can be applied for manufacture of an electronic devises such as a semiconductor, a flat panel display (FPD) , etc. particularly for a formation of a planarization film or an interlayer dielectric film of a semiconductor device and an FPD, etc.

## Claims

1. A photosensitive resin composition comprising an alkali-soluble resin and a photosensitizer having a quinone diazide group, wherein the alkali-soluble resin is an acrylic resin and the photosensitive resin composition further comprises a phenolic compound represented by the general formula (I): 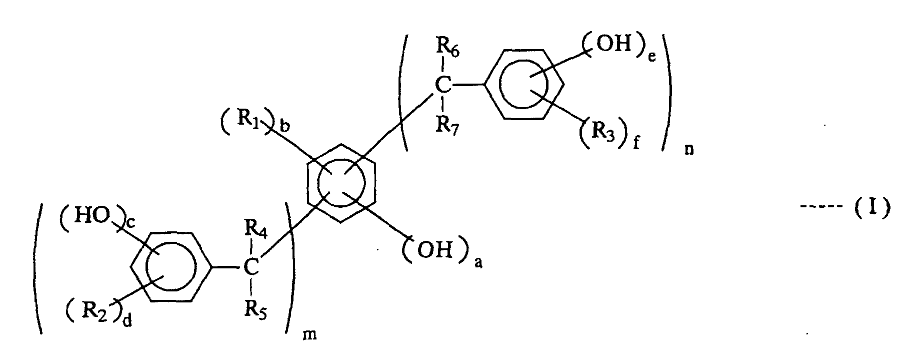 wherein R₁, R₂, R₃, R₄, R₅, R₆ and R₇ independently represent H, a C₁₋₄ alkyl group or 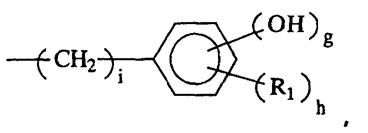 m and n independently represent an integer of 0 to 2, each of a, b, c, d, e, f, g and h is an integer of 0 to 5 satisfying a + b ≤ 5, c + d ≤ 5, e + f ≤ 5 and g + h ≤ 5, and i is an integer of 0 to 2.

2. The photosensitive resin composition according to claim 1, wherein the acrylic resin comprises a constitutional unit derived from alkyl(meth)acrylate and a constitutional unit derived from (meth)acrylic acid.

3. The photosensitive resin composition according to claim 1 or 2, wherein the acrylic resin includes 5 to 30 mole-% of a constitutional unit derived from (meth)acrylic acid.

4. The photosensitive resin composition according to any one of claims 1 to 3, wherein the photosensitizer having a quinone diazide group is a reaction product of a compound represented by the general formula (I) above with a naphthoquinone diazide compound.

5. The photosensitive resin composition according to any one of claims 1 to 4, wherein the phenolic compound represented by the general formula (I) is a compound represented by the formula (II):

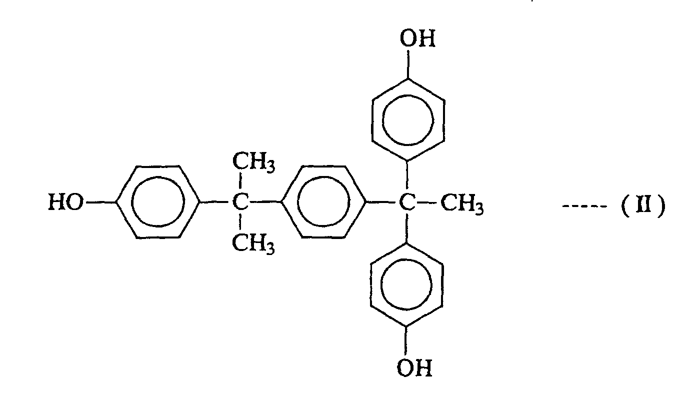

6. The photosensitive resin composition according to any one of claims 1 to 5, wherein the average molecular weight of the acrylic resin as determined by polystyrene standards is 20,000 to 40,000.

7. The photosensitive resin composition according to any one of claims 1 to 6, which comprises a hardening agent having an epoxy group.

8. The photosensitive resin composition according to claim 7, wherein the hardening agent having an epoxy group is a three-functional epoxy resin.

9. A flat panel display having a planarization film or an interlayer dielectric film formed from the photosensitive resin composition described in any one of claims 1 to 8.

10. A semiconductor device having a planarization film or an interlayer dielectric film formed from the photosensitive resin composition described in any one of claims 1 to 8.

11. A method of forming a heat-resistant thin film, which comprises patterning with the photosensitive resin composition described in any one of claims 1 to 6 and subsequent post-baking without flat-exposure to light.

12. A method of forming a heat-resistant thin film, which comprises patterning with the photosensitive resin composition described in claim 7 or 8 and subsequent flat-exposure to light followed by post-baking.
